(19) Europäisches Patentamt
European Patent Office
Office européen des brevets

(11) Publication number: 0 372 944 A2

(12) # EUROPEAN PATENT APPLICATION

(21) Application number: 89312742.3

(22) Date of filing: 07.12.89

(51) Int. Cl.5: G03F 7/00, C08F 291/18

(30) Priority: 07.12.88 JP 307810/88
07.02.89 JP 26677/89

(43) Date of publication of application:
13.06.90 Bulletin 90/24

(84) Designated Contracting States:
CH DE FR GB LI

(71) Applicant: MITSUBISHI RAYON CO., LTD.
3-19, Kyobashi 2-chome Chuo-Ku
Tokyo 104(JP)

(72) Inventor: Kushi, Kenji Central Research Lab. Mitsubishi
Rayon Co. Ltd. 20-1, Miyukicho Otake-shi
Hiroshima-ken(JP)
Inventor: Inukai, Ken-ichi Central Research Lab. Mitsubishi
Rayon Co. Ltd. 20-1, Miyukicho Otake-shi
Hiroshima-ken(JP)
Inventor: Iseki, Takayuki Central Research Lab. Mitsubishi
Rayon Co. Ltd. 20-1, Miyukicho Otake-shi
Hiroshima-ken(JP)
Inventor: Fujimoto, Yasuyki Central Research Lab. Mitsubishi
Rayon Co. Ltd. 20-1, Miyukicho Otake-shi
Hiroshima-ken(JP)

(74) Representative: Lawrence, Peter Robin Broughton et al
GILL JENNINGS & EVERY 53-64 Chancery Lane
London WC2A 1HN(GB)

(54) **Photopolymerizable resin composition and gold plating method using same.**

(57) Disclosed is a photopolymerizable resin composition consisting essentially of

(A) 40 to 70 parts by weight of a thermoplastic polymer binder obtained by copolymerizing 3 to 30% by weight of a styrene type constituent, 15 to 45% by weight of an acrylate type constituent, 25 to 60% by weight of a methacrylate type constituent, and 15 to 35% by weight of a carboxylic acid type constituent, the thermoplastic polymer binder having a Tg of 60 to 100° C;

(B) 25 to 50 parts by weight of a crosslinkable monomer comprising one or more compounds having one or more ethylenically unsaturated groups in the molecule and containing not less than 5% by weight of one or more compounds having one or more hydroxyl groups and two or more ethylenically unsaturated groups in the molecule; and

(C) 0 to 10 parts by weight of a photopolymerization initiator; the combined amount of components (A) to (C) being 100 parts by weight.

EP 0 372 944 A2

## Photopolymerizable Resin Composition and Gold Plating Method Using Same

This invention relates to photopolymerizable resin compositions which can be developed with an aqueous alkaline solution, and a gold plating method using such a resin composition as a resist for protection against plating.

In recent years, so-called dry film resists comprising a layer of photopolymerizable resin sandwiched between supporting films are being widely used as photoresists for the fabrication of printed wiring boards.

One of the especially important performance requirements of photoresists for use in the fabrication of printed wiring boards is that they are not attacked by such fluids as plating solutions and can hence protect the substrates covered therewith satisfactorily. For example, it has been known that, if a separation of the cured resist occurs during high throwing power tin-lead plating, the plating solution penetrates between the cured resist and the copper surface and causes deposition of solder on non-circuit areas, resulting in various defects such as short circuits between conductive lines, a widening of conductive lines, and a disturbance of the shapes of conductive patterns.

Since these defects are attributable to insufficiency of the adhesion between the cured resist and the copper surface, extensive studies are being carried on for the purpose of developing effective adhesion promoters. For example, it is proposed in U.S. Pat. No. 3,622,334 to add heterocyclic nitrogen-containing compounds, such as benzotriazole and benzimidazole, to photopolymerizable resin compositions.

Although such compounds can suppress the occurrence of under-plating in case of high throwing power tin-lead plating, they fail to provide satisfactorily high adhesion to copper surfaces. Accordingly, when used in gold plating having low current efficiency, the cured resist may very easily separate from the copper surface, resulting in serious defects such as short circuits between conductive lines and a widening of conductive lines. Especially in the case of alkali-developing type photopolymerizable resins or dry film resists which can be developed with a solution of sodium carbonate or the like, no product capable of resisting gold plating solutions has been available for practical purposes.

It is an object of the present invention to provide a photopolymerizable resin composition which has excellent resistance to gold plating solutions and can be developed with an aqueous alkaline solution.

It is another object of the present invention to provide a photopolymerizable resin composition which has good adhesion to substrates such as copper plates and is less liable to under-plating even in case of gold plating having low current efficiency.

According to the present invention, there is provided a photopolymerizable resin composition comprising

(A) 40 to 70 parts by weight of a thermoplastic polymer binder obtained by copolymerizing

(1) 3 to 30% by weight of a first polymerizable substance comprising one or more compounds selected from the group consisting of styrene type compounds of the general formula

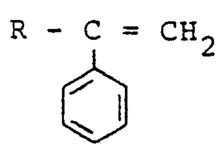

(I)

where R is hydrogen, an alkyl group of 1 to 6 carbon atoms, or a halogen, and ring-substituted derivatives thereof,

(2) 15 to 45% by weight of a second polymerizable substance comprising one or more compounds selected from the group consisting of alkyl acrylates having an alkyl group of 1 to 8 carbon atoms, and hydroxyalkyl acrylates having a hydroxyalkyl group of 2 to 8 carbon atoms,

(3) 25 to 60% by weight of a third polymerizable substance comprising one or more compounds selected from the group consisting of alkyl methacrylates having an alkyl group of 1 to 8 carbon atoms, and hydroxyalkyl methacrylates having a hydroxyalkyl group of 2 to 8 carbon atoms, and

(4) 15 to 35% by weight of a fourth polymerizable substance comprising one or more α,β-unsaturated carboxyl-containing monomers having 3 to 15 carbon atoms,

the thermoplastic polymer binder having a glass transition temperature (Tg) of 60 to 100°C as measured by differential scanning calorimetry (DSC);

(B) 25 to 50 parts by weight of a crosslinkable monomer comprising one or more compounds having one or more ethylenically unsaturated groups in the molecule and containing not less than 5% by weight of one or more compounds having one or more hydroxyl groups and two or more ethylenically unsaturated

groups in the molecule; and

(C) 0 to 10 parts by weight of a photopolymerization initiator; the combined amount of components (A) to (C) being 100 parts by weight.

The various components constituting the photopolymerizable resin compositions of the present invention are more specifically described hereinbelow.

First of all, the thermoplastic polymer binder (A) constituting the photopolymerizable resin compositions of the present invention is a copolymer of four polymerizable substances.

A first polymerizable substance constituting the thermoplastic polymer binder (A) is a compound of the general formula

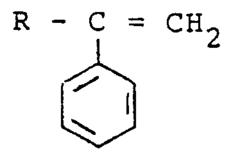

where R is as previously defined, or a derivative thereof. The benzene ring of this compound may be substituted by functional groups such as nitro, alkoxy, acyl, carboxyl, sulfone and hydroxyl groups and halogen atoms. The benzene ring may have 1 to 5 substituent groups. Preferred substituent groups are single alkyl groups such as methyl and tert-butyl groups. The compound most suitable for use as the first polymerizable substance is styrene.

This styrene type constituent (first polymerizable substance) is used in such an amount that its content in the copolymer is in the range of 3 to 30% by weight, preferably 5 to 25% by weight. If its content in the copolymer is less than 3% by weight, the resulting composition will fail to have sufficient chemical resistance and gold plating resistance. On the other hand, if its content in the copolymer is greater than 30% by weight, the resulting dry film resist will be excessively hard and may easily separate from the substrate.

A second polymerizable substance constituting the thermoplastic polymer binder (A) is an alkyl acrylate having an alkyl group of 1 to 8 carbon atoms and/or a hydroxyalkyl acrylate having a hydroxyalkyl group of 2 to 8 carbon atoms. Examples of the second polymerizable substance include methyl acrylate, ethyl acrylate, n-propyl acrylate, isopropyl acryalte, n-butyl acryalte, sec-butyl acrylate, tert-butyl acrylate, 2-hydroxyethyl acrylate, 2-hydroxypropyl acrylate and 2-ethylhexyl acrylate. This acrylate type constituent (second polymerizable substance) should be used in such an amount that its content in the copolymer is in the range of 15 to 45% by weight, preferably 20 to 40% by weight. If its content in the copolymer is less than 15% by weight, the resulting dry film resist will fail to have a sufficient degree of flexibility. Thus, the dry film resist will have poor adhesion to the substrate and the resin composition will fail to fill up irregularities of the substrate surface, causing a reduction in gold plating resistance. On the other hand, if its content in the copolymer is greater than 45% by weight, the resulting resin composition will be so soft that, when it is formed into a dry film resist and stored in the form of a roll, it may suffer from the so-called cold flow phenomenon in which the resin composition flows from between the supporting films with the lapse of time.

A third polymerizable substance constituting the thermoplastic polymer binder (A) is an alkyl methacrylate having an alkyl group of 1 to 8 carbon atoms and/or a hydroxyalkyl methacrylate having a hydroxyalkyl group of 2 to 8 carbon atoms. Examples of the third polymerizable substance include methyl methacrylate, ethyl methacrylate, n-propyl methacrylate, isopropyl methacrylate, n-butyl methacrylate, sec-butyl methacrylate, tert-butyl methacrylate, 2-hydroxyethyl methacrylate, 2-hydroxypropyl methacrylate and 2-ethylhexyl methacrylate. This methacrylate type constituent (third polymerizable substance) should be used in such an amount that its content in the copolymer is in the range of 25 to 60% by weight, preferably 30 to 55% by weight.

A fourth polymerizable substance constituting the thermoplastic polymer binder (A) is an $\alpha,\beta$-unsaturated carboxyl-containing monomer having 3 to 15 carbon atoms and preferably 3 to 6 carbon atoms. The most preferred compounds are acrylic acid and methacrylic acid. Other examples of the fourth polymerizable substance include cinnamic acid, crotonic acid, sorbic acid, itaconic acid, propiolic acid, maleic acid and fumaric acid. In addition, half esters and anhydrides thereof can also be used. This carboxylic acid type constituent (fourth polymerizable substance) should be used in such an amount that its content in the copolymer is in the range of 15 to 35% by weight, preferably 18 to 30% by weight. If its content in the copolymer is less than 15% by weight, the resulting dry film resist cannot be developed with an aqueous

alkaline solution or may require an excessively long developing time which would cause a reduction in resolution. On the other hand, if its content in the copolymer is greater than 35% by weight, the developing time will become so short that it is difficult to control the development so as to obtain high-resolution patterns. Moreover, the cured portions will show a reduction in water resistance.

In order to accomplish the objects of the present invention, the thermoplastic polymer binder (A) should be a polymer composed of the above-described specific monomers, and preferably has a weight average molecular weight of 40,000 to 200,000. If the weight average molecular weight is less than 40,000, the resulting dry film resist may suffer from the cold flow phenomenon. On the other hand, if the weight average molecular weight is greater than 200,000, the resulting dry film resist cannot be developed because its unexposed portions are undissolvable, or it may require such a long developing time as to cause a reduction in resolution.

Moreover, the thermoplastic polymer binder (A) should have a Tg of 60 to 100°C, preferably 70 to 95°C, as measured by DSC. If Tg is higher than 100°C, the resulting dry film resist will fail to have a sufficient degree of flexibility. Thus, the dry film resist will have poor adhesion to the substrate and the resist resin will fail to fill up irregularities of the substrate surface, causing a reduction in gold plating resistance. On the other hand, if Tg is lower than 60°C, the resulting resin composition will be so soft that the dry film resist formed therefrom may suffer from the cold flow phenomenon.

In the photopolymerizable resin compositions of the present invention, the thermoplastic polymer binder (A) is used in an amount of 40 to 70 parts by weight, preferably 45 to 65 parts by weight, per 100 parts by weight of the combined amount of components (A) to (C) of the photopolymerizable resin composition. If its amount is less than 40 parts by weight, the film-forming properties of the resulting photosensitive layer will be impaired. Thus, the resulting film will fail to have sufficient strength and may suffer from cold flow. On the other hand, if its amount is greater than 70 parts by weight, the resulting photo-cured film will be brittle and will have poor adhesion to the substrate. Thus, sufficient gold plating resistance cannot be achieved.

The crosslinkable monomer (B) constituting the photopolymerizable resin compositions of the present invention comprises one or more compounds having one or more ethylenically unsaturated groups in the molecule and contains not less than 5% by weight of one or more compounds having one or more hydroxyl groups and two or more ethylenically unsaturated groups in the molecule.

Examples of the compounds having one or more hydroxyl groups and two or more ethylenically unsaturated groups in the molecule [acrylate and methacrylate will hereinafter be abbreviated as (meth)-acrylate] include glycerol di(meth)acrylate, trimethylolethane di(meth)acrylate, trimethylolpropane di(meth)-acrylate, pentaerythritol di(meth)acrylate, pentaerythritol tri(meth)acrylate, dipentaerythritol tri(meth)acrylate, dipentaerythritol tetra(meth)acrylate, dipentaerythritol penta(meth)acrylate, triethylol isocyanurate di(meth)-acrylate, and compounds formed by the addition of two or more molecules of (meth)acrylic acid to one molecule of an epoxy resin. Among them, compounds having one or more hydroxyl groups and three or more ethylenically unsaturated groups in the molecule are preferred and examples thereof include pentaerythritol tri(meth)acrylate, dipentaerythritol tri(meth)acrylate, dipentaerythritol tetra(meth)acrylate, dipentaerythritol penta(meth)acrylate, and compounds formed by the addition of three or more molecules of (meth)acrylic acid to one molecule of an epoxy resin. The most preferred compounds are pentaerythritol triacrylate and dipentaerythritol pentaacrylate.

The crosslinkable monomer (B) used in the photopolymerizable resin compositions of the present invention comprises one or more of the above-described compounds or a mixture of one or more of the above-described compounds and one or more other compounds having one or more ethylenically unsaturated groups in the molecule wherein the former compound or compounds are present in an amount of not less than 5% by weight, preferably not less than 10% by weight. Examples of the latter compounds include n-butoxymethyl acrylamide, isobutoxymethyl acrylamide, phenoxydiethoxy (meth)acrylate, polyethylene glycol di(meth)acrylate, polypropylene glycol di(meth)acrylate, 1,3-butylene glycol di(meth)acrylate, 1,6-hexanediol di(meth)acrylate, neopentyl glycol di(meth)acrylate, 2,2-bis[4-(meth)-acryloyloxypolyethoxyphenyl]propane, 2,2-bis[4-(meth)acryloyloxypolyopropylenoxyphenyl]propane, neopentyl glycol hydroxypivalate di(meth)acrylate, trimethylolethane tri(meth)acrylate, trimethylolpropane tri-(meth)acrylate, trimethylolpropane tris[polyethoxy(meth)acrylate], trimethylolpropane tris[polypropylenoxy-(meth)acrylate], triethylol isocyanurate tri(meth)acrylate, pentaerythritol tetra(meth)acrylate and dipentaerythritol hexa(meth)acrylate.

If the compound or compounds having one or more hydroxyl groups and two or more ethylenically unsaturated groups in the molecule are contained in the crosslinkable monomer (B) in an amount of less than 5% by weight, the resulting composition will not have sufficient gold plating resistance.

In order to impart excellent gold plating resistance to the photopolymerizable resin compositions of the present invention, it is particularly important to incorporate a specific amount of the above-specified

crosslinkable component in the above-specified thermoplastic polymer binder. Compositions outside the above-described range fail to exhibit excellent gold plating resistance that is aimed at by the present invention. The use of a thermoplastic polymer binder having the above-described composition can improve the chemical resistance (i.e., resistance to gold plating solutions) of the resulting resist and its property of filling up irregularities of the substrate surface, both required for the improvement of its gold plating resistance. Especially when not less than a specific amount of a compound having one or more hydroxyl groups and two or more ethylenically unsaturated groups in the molecule is incorporated in the above-specified thermoplastic polymer binder, the resulting photopolymerizable resin composition exhibits unexpectedly excellent gold plating resistance. Although its exact mechanism has not been fully elucidated, it is supposed that, when the photopolymerizable resin composition is cured, the compound having one or more hydroxyl groups and two or more ethylenically unsaturated groups in the molecule is crosslinked to such a degree as not to allow the gold plating solution to permeate into the cured resin composition and, moreover, the hydroxyl groups of the compounds exercise unexpected interactions with the carboxyl-containing thermoplastic polymer binder and the copper surface of the substrate, thus bringing about an improvement in gold plating resistance.

In the photopolymerizable resin compositions of the present invention, the crosslinkable monomer (B) is used in an amount of 25 to 50 parts by weight, preferably 30 to 45 parts by weight, per 100 parts by weight of the combined amount of components (A) to (C) of the photopolymerizable resin composition. If its amount is less than 25 parts by weight, the resulting composition cannot be cured to a full degree and will show a reduction in chemical resistance and gold plating resistance. On the other hand, if its amount is greater than 50 parts by weight, the resulting dry film resist will tend to suffer from cold flow and the cured product thereof will be hard and brittle and may be easily stripped from the substrate.

The photopolymerization initiator (C) constituting the photopolymerizable resin compositions of the present invention can be any of conventional photopolymerization initiators including, for example, benzophenone, Michler's ketone, 4,4′-bis(diethylamino)benzophenone, t-butylanthraquinone, 2-ethylanthraquinone, thioxanthones, benzoin alkyl ethers and benzyl ketals. These polymerization initiators may be used alone or in combination.

Where it is desired to cure the photopolymerizable resin compositions of the present invention by means of ultraviolet radiation, the photopolymerization initiator (C) is used in an amount of 0.1 to 10 parts by weight per 100 parts by weight of the combined amount of components (A) to (C) of the photopolymerizable resin composition. If its amount is less than 0.1 part by weight, the resulting composition cannot be photo-cured to a full degree, and if its amount is greater than 10 parts by weight, the resulting composition will be thermally unstable. Where it is desired to cure the photopolymerizable resin compositions of the present invention by means of electron rays, the photopolymerization initiator (C) may be eliminated.

In order to further improve their gold plating resistance, the photopolymerizable resin compositions of the present invention may preferably contain tetrazole or a derivative thereof. The addition of a small amount of tetrazole or a derivative thereof can improve adhesion to metallic surfaces. Examples of tetrazole derivatives include 1-phenyltetrazole, 5-phenyltetrazole, 5-aminotetrazole, 5-amino-1-methyltetrazole, 5-amino-2-phenyltetrazole, 5-mercapto-1-phenyltetrazole and 5-mercapto-1-methyltetrazole. These tetrazole derivatives may be used alone or in combination. The amount of this additive used in the composition may vary according to the types and proportions of the components of the resin composition, and the hardness of the photo-cured resin composition. However, in order to achieve satisfactory gold plating resistance, this additive is used in an amount of 0.005 to 5 parts by weight, preferably 0.01 to 1 part by weight, per 100 parts by weight of the combination of the thermoplastic polymer binder (A), the crosslinkable monomer (B) and the photopolymerization initiator (C). If its amount is less than 0.005 part by weight, the resulting resin composition will have insufficient resistance to gold plating performed at a high current density for a long time. On the other hand, if its amount is greater than 5 parts by weight, it takes a long time to dissolve the additive in the resin composition and, moreover, the resulting resin composition will show a reduction in sensitivity.

The addition of tetrazole or a derivative thereof is especially preferred when the current density for gold plating is increased to shorten the gold plating time from the viewpoint of industrial productivity, or when the gold plating time is prolonged or the current density is increased to thicken the deposited gold layer from the viewpoint of reliability. The addition of tetrazole or a derivative thereof markedly improves gold plating resistance under severe conditions including high current densities and long plating times. Unlike tetrazole and its derivatives, other compounds such as benzotriazole, benzimidazole and 2-mercaptobenzothiazole are not effective in this respect. It is to be understood that the use of large amounts of tetrazole or a derivative thereof is undesirable because this will reduce the sensitivity of the resulting photopolymerizable

resin composition and because this additive will remain on the copper surface even after development or stripping, thus impairing the adhesion of the deposited gold layer and retarding subsequent etching.

If necessary, the photopolymerizable resin compositions of the present invention can further contain additives such as thermal polymerization inhibitors, dyes, plasticizers and fillers.

The photopolymerizable resin compositions of the present invention can be directly formed into films on desired substrates, without using any diluent. However, the formation of films is facilitated by mixing and dissolving them in a solvent having a relatively low boiling point. Useful solvents include, for example, acetone, methyl ethyl ketone, methyl cellosolve, ethyl cellosolve, dichloromethane, chloroform, methyl alcohol, ethyl alcohol and isopropyl alcohol. These solvents may be used alone or in combination. These solvents are used in an amount of not greater than 200 parts by weight, preferably 50 to 200 parts by weight, per 100 parts by weight of the photopolymerizable resin composition.

In order to form a dry film resist using a photopolymerizable resin composition prepared in accordance with the present invention, the composition may be applied with any of various means such as a blade coater, rod coater, knife coater, roll doctor coater, comma coater, reverse-roll coater, transfer roll coater, gravure coater, kiss-roll coater and a curtain coater.

The support on which a dry film resist is formed usually comprises a plastic film made of polyester or the like.

The dry film resist so formed is then subjected to forced drying with a dryer for the purpose of expelling the solvent. Where a combustible solvent is used, it is necessary from the viewpoint of safety to employ a dryer equipped with a heat source in which air is heated with steam. For the present purpose, the dryer may be of a type in which hot air is supplied countercurrently and brought into contact with the substrate, or of a type in which hot air is directly blown from nozzles onto the substrate. With respect to its shape, the dryer may be selected from among arch type, flat type and other dryers according to the intended purpose.

After drying, the dry film resist may be laminated with a protective film of polyethylene or polypropylene, if necessary.

Dry film resists formed from the photopolymerizable resin compositions of the present invention can be used not only as resists for metal plating, particularly for gold plating, but also as resists for etching. When used in the latter application, they exhibit excellent workability and in-process durability, thus making it possible to create high-resolution patterns.

The photopolymerizable resin compositions of the present invention have very good adhesion to substrates and very good chemical resistance, and hence exhibit very excellent resistance to various plating solutions. Alkali-developing type dry film resists formed from the photopolymerizable resin compositions of the present invention are very useful for industrial purposes, in that they exhibit excellent resistance to plating solutions even in case of gold plating having low current efficiency and, moreover, they can provide high productivity.

The present invention is further illustrated by the following examples.

## Synthesis Example

A 1000-ml four-necked flask fitted with a nitrogen inlet, stirrer, condenser and a thermometer was charged with 100 g of isopropyl alcohol, 100 g of methyl ethyl ketone, and 200 g of each of the polymerizable monomer mixtures having the respective compositions shown in Table 1, under an atmosphere of nitrogen. While the contents of the flask were stirred, the temperature of the water bath was raised to 80 °C. Then, a solution of 1.0 g of azobisbutyronitrile in 10 g of isopropyl alcohol was added and the resulting mixture was polymerized for 4 hours. Moreover, a solution of 1.0 g of azobisbutyronitrile in 10 g of isopropyl alcohol was added thereto in five portions at intervals of 30 minutes. Thereafter, the internal temperature of the flask was raised to the boiling point of the solvent and the polymerization was continued for 2 hours at that temperature. After completion of the polymerization, 100 g of isopropyl alcohol was added and the polymerization product was taken out of the flask. Thus, there were obtained binder resin solutions A to J. For all monomer mixtures, the degree of conversion was 99.5% or higher.

Samples of the above binder resin solutions were thoroughly freed of solvent to obtain solid binder resins. All binder resin solutions had a solid content of 38.7% by weight. The glass transition temperature (Tg's) of the resulting solid binder resins were measured by differential scanning calorimetry (DSC). The results thus obtained are shown in Table 1.

Table 1

| | Composition of polymerizable monomer mixture (weight ratio) | | | | | | | |
|---|---|---|---|---|---|---|---|---|
| Binder resin | Styrene | Methyl acrylate | Ethyl acrylate | n-Butyl acryalte | 2-Ethylhexyl acryalte | Methyl methacryalte | Methacrylic acid | Tg (°C) |
| A | 15 | 30 | - | - | - | 35 | 20 | 80 |
| B | 20 | 20 | - | - | - | 40 | 20 | 92 |
| C | 5 | 35 | - | - | - | 40 | 20 | 75 |
| D | 40 | 20 | - | - | - | 20 | 20 | 91 |
| E | 15 | 10 | - | - | - | 50 | 25 | 108 |
| F | 10 | 55 | - | - | - | 15 | 20 | 55 |
| G | 5 | - | 20 | - | - | 50 | 25 | 85 |
| H | 20 | - | - | 20 | - | 35 | 25 | 73 |
| I | 7 | - | - | - | 20 | 45 | 28 | 71 |
| J | - | 30 | - | - | - | 50 | 20 | 81 |

Examples 1-19 and Comparative Examples 1-8

Using the binder resin solutions obtained in the foregoing Synthesis Example, various photopolymerizable resin compositions were prepared according to the formulations shown in Table 2.

Each of the prepared compositions was agitated with a propeller mixer and applied with a blade coater onto a polyester film, 25 µm thick and 360 mm wide, so as to give a coating width of 340 mm. Then, the coated polyester film was passed through a flat type dryer having a width of 400 mm, a height of 100 mm and a length of 8 m, in which hot air was supplied countercurrently to obtain a dry coating film thickness of 50 µm. The coating speed was 5 m per minute and the temperature of the hot air was 90°C. Then, the dry coating film was laminated with a protective film of polyethylene, 35 µm thick, to obtain a dry film resist. This dry film resist, which had a length of 120 m, was rolled up. The rolls thus obtained were laid on their side in a constant temperature room at 23°C and allowed to stand for 5 days. Thereafter, they were visually examined for the occurrence of cold flow from their ends. The results of examination are shown in Table 3.

While the protective film was being removed, each of the dry film resists was heat-laminated to copper-clad laminates so that the coating film was in contact with their copper surface. After the copper-clad laminates cooled to room temperature, a photo tool was brought into contact with the polyester film surface and the dry film resist was exposed to radiation from an ultrahigh pressure mercury vapor lamp. For this purpose, a USH-102D ultrahigh pressure mercury vapor lamp (manufactured by Ushio Inc.) was used and its intensity of irradiation was 100 $mJ/cm^2$. When measured with a UIT-100 ultraviolet photometer (manufactured by Ushio Inc.) equipped with a UVD-365P photo detector, the magnitude of the exposure energy was 5 $mW/cm^2$.

After exposure, the resulting laminates were allowed to stand for 20 minutes, stripped of the supporting film, and then developed with a 1% aqueous solution of sodium carbonate. The development was performed at a solution temperature of 27°C and a spray pressure of 1.2 $kg/cm^2$, using a spray nozzle held at a distance of 10 cm from the substrate. Thereafter, the laminates were degreased by immersing them in an acid degreasing agent at 45°C for 2 minutes, washed with water spray in an overflow tank for about one minute, and then immersed in a 20 wt% aqueous solution of ammonium persulfate for one minute. Subsequently, the laminates were washed again with water spray for one minute, immersed in a 10% aqueous solution of sulfuric acid for one minute, and further washed with water spray for one minute. Thereafter, the laminates were immersed in a nickel plating solution (Watts bath) and plated at 1.5 $A/dm^2$ for 10 minutes. During this plating, the solution temperature was 45°C. After completion of the plating the laminates were immediately washed with water for one minute and then gold-plated under one of the following three conditions: 1.0 $A/dm^2$ x 12 minutes, 1.0 $A/dm^2$ x 15 minutes and 1.3 $A/dm^2$ x 15 minutes. As the gold plating solution, Autronex CI (manufactured by Electroplating Engineers of Japan Ltd.) was used at a solution temperature of 30°C. After completion of this plating, the laminates were washed with water, treated with a 3% aqueous solution of sodium hydroxide to strip the dry film resist therefrom, and then immersed in a 20 wt% aqueous solution of ammonium persulfate to etch the copper layer. Thereafter, the

laminates were examined for the presence of under-plating. Their gold plating resistance was evaluated according to the following criteria:

O = Neither under-plating nor bridge (or short circuit) formation was observed.

Δ = Under-plating was observed, but no bridge was formed.

X = Bridges between conductive patterns were observed.

The results thus obtained are shown in Table 3.

Table 2-1

| Component | Example No. | | | | | | | | | | |
|---|---|---|---|---|---|---|---|---|---|---|---|
| | 1 | 2 | 3 | 4 | 5 | 6 | 7 | 8 | 9 | 10 | 11 |
| Binder resin solution A | 150 | | | | | | 120 | 165 | 150 | 150 | 150 |
| " B | | 150 | | | | | | | | | |
| " C | | | 150 | | | | | | | | |
| " D | | | | | | | | | | | |
| " E | | | | | | | | | | | |
| " F | | | | | | | | | | | |
| " G | | | | 150 | | | | | | | |
| " H | | | | | 150 | | | | | | |
| " I | | | | | | 150 | | | | | |
| " J | | | | | | | | | | | |
| Pentaerythritol triacrylate | 25 | 25 | 25 | 25 | 25 | 25 | 35 | 22 | 7.5 | | |
| Dipentaerythritol pentaacrylate | | | | | | | | | | 15 | |
| Bisphenol A diglycidyl ether diacrylate | | | | | | | | | | | 20 |
| Propylene glycol diglycidyl ether diacrylate | | | | | | | | | | | |
| Tetraethylene glycol diacrylate | 10 | 10 | 10 | 10 | 10 | 10 | 12 | 8 | 15 | 20 | 15 |
| Trimethylolpropane triacrylate | | | | | | | | | 12.5 | | |
| 5-Phenyltetrazole | | | | | | | | | | | |
| 5-Aminotetrazole | | | | | | | | | | | |
| Benzotriazole | | | | | | | | | | | |
| Benzophenone | 6 | 6 | 6 | 6 | 6 | 6 | 5.6 | 5.1 | 6 | 6 | 6 |
| Michler's ketone | 1 | 1 | 1 | 1 | 1 | 1 | 1 | 1 | 1 | 1 | 1 |
| Methylene blue | 0.2 | 0.2 | 0.2 | 0.2 | 0.2 | 0.2 | 0.2 | 0.2 | 0.2 | 0.2 | 0.2 |

- to be cont'd. -

Table 2-1 (Cont'd.)

| | | | | | | | |
|---|---|---|---|---|---|---|---|
| 12 | 13 | 14 | 15 | 16 | 17 | 18 | 19 |
| 150 | 150 | 150 | 150 | 150 | 150 | 150 | 150 |
| | | | | | | | |
| | | | | | | | |
| | | | | | | | |
| | | | | | | | |
| | | | | | | | |
| | | | | | | | |
| | | | | | | | |
| | | | | | | | |
| | | | | | | | |
| | 15 | 25 | 25 | 25 | | 25 | 25 |
| | 10 | | | | 15 | | |
| | | | | | | | |
| 20 | | | | | | | |
| 15 | 10 | 10 | 10 | 10 | 20 | 10 | 10 |
| | | | | | | | |
| | | | | | | 0.3 | |
| | | 0.01 | 0.3 | 1.0 | 0.3 | | |
| | | | | | | | 0.3 |
| 6 | 6 | 6 | 6 | 6 | 6 | 6 | 6 |
| 1 | 1 | 1 | 1 | 1 | 1 | 1 | 1 |
| 0.2 | 0.2 | 0.2 | 0.2 | 0.2 | 0.2 | 0.2 | 0.2 |

Notes:

1) All figures represent parts by weight.

2) All binder resin solutions have a solid content of 38.7% by weight. Accordingly, 120, 150 or 165 parts by weight of a binder resin solution contains 46.4, 58.0 or 63.9 parts by weight of solid matter, respectively.

Table 2-2

| | Comparative Example No. | | | | | | | |
|---|---|---|---|---|---|---|---|---|
| Component | 1 | 2 | 3 | 4 | 5 | 6 | 7 | 8 |
| Binder resin solution A | | | | | 100 | 185 | 150 | 150 |
| " B | | | | | | | | |
| " C | | | | | | | | |
| " D | 150 | | | | | | | |
| " E | | 150 | | | | | | |
| " F | | | 150 | | | | | |
| " G | | | | | | | | |
| " H | | | | | | | | |
| " I | | | | | | | | |
| " J | | | | 150 | | | | |
| Pentaerythritol triacrylate | 25 | 25 | 25 | 25 | 38 | 16 | | 1.5 |
| Dipentaerythritol pentaacrylate | | | | | | | | |
| Bisphenol A diglcidyl ether diacrylate | | | | | | | | |
| Propylene glycol diglycidyl ether diacrylate | | | | | | | | |
| Tetraethylene glycol diacryalte | 10 | 10 | 10 | 10 | 16 | 6 | 10 | 15 |
| Trimethylolpropane triacrylate | | | | | | | 25 | 18.5 |
| 5-Phenyltetrazole | | | | | | | | |
| 5-Aminotetrazole | | | | | | | | |
| Benzotriazole | | | | | | | | |
| Benzophenone | 6 | 6 | 6 | 6 | 6.3 | 5.4 | 6 | 6 |
| Michler's ketone | 1 | 1 | 1 | 1 | 1 | 1 | 1 | 1 |
| Methylene blue | 0.2 | 0.2 | 0.2 | 0.2 | 0.2 | 0.2 | 0.2 | 0.2 |

Notes:

1) All figures represent parts by weight.

2) All binder resin solutions have a solid content of 38.7% by weight. Accordingly, 100, 150 or 185 parts by weight of a binder resin solution contains 38.7, 58.0 or 71.6 parts by by weight of solid matter, respectively.

Table 3

| | | Gold plating resistance (see notes.) | | | |
|---|---|---|---|---|---|
| | Gold flow | Condition 1 | Condition 2 | Condition 3 | Remarks |
| Example 1 | No | O | O | X | |
| " 2 | No | O | O | X | |
| " 3 | No | O | O | X | |
| " 4 | No | O | O | X | |
| " 5 | No | O | O | X | |
| " 6 | No | O | O | X | |
| " 7 | No | O | O | X | |
| " 8 | No | O | O | X | |
| " 9 | No | O | O | X | |
| " 10 | No | O | O | X | |
| " 11 | No | O | Δ | X | |
| " 12 | No | O | Δ | X | |
| " 13 | No | O | O | X | |
| " 14 | No | O | O | O | |
| " 15 | No | O | O | O | |
| " 16 | No | O | O | O | |
| " 17 | No | O | O | O | |
| " 18 | No | O | O | O | |
| " 19 | No | O | O | X | |
| Comparative Example 1 | No | Δ | X | X | Very long developing time |
| " 2 | No | X | X | X | |
| " 3 | Yes | O | O | X | |
| " 4 | No | X | X | X | |
| " 5 | Yes | O | O | X | Long stripping time |
| " 6 | No | Δ | X | X | |
| " 7 | No | X | X | X | |
| " 8 | No | X | X | X | |
| Notes: | | | | | |
| Condition 1 = 1.0 A/dm$^2$ x 12 min.<br>Condition 2 = 1.0 A/dm$^2$ x 15 min.<br>Condition 3 = 1.3 A/dm$^2$ x 15 min. | | | | | |

**Claims**

1. A photopolymerizable resin composition comprising
(A) 40 to 70 parts by weight of a thermoplastic polymer binder obtained by copolymerizing
(1) 3 to 30% by weight of a first polymerizable substance comprising one or more compounds selected from the group consisting of styrene type compounds of the general formula

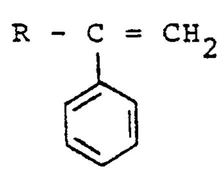

(I)

where R is hydrogen, an alkyl group of 1 to 6 carbon atoms, or a halogen, and ring-substituted derivatives

thereof,
(2) 15 to 45% by weight of a second polymerizable substance comprising one or more compounds selected from the group consisting of alkyl acrylates having an alkyl group of 1 to 8 carbon atoms, and hydroxyalkyl acrylates having a hydroxyalkyl group of 2 to 8 carbon atoms,
(3) 25 to 60% by weight of a third polymerizable substance comprising one or more compounds selected from the group consisting of alkyl methacrylates having an alkyl group of 1 to 8 carbon atoms, and hydroxyalkyl methacrylates having a hydroxyalkyl group of 2 to 8 carbon atoms, and
(4) 15 to 35% by weight of a fourth polymerizable substance comprising one or more α,β-unsaturated carboxyl-containing monomers having 3 to 15 carbon atoms,
the thermoplastic polymer binder having a glass transition temperature (Tg) of 60 to 100°C as measured by differential scanning calorimetry (DSC);
(B) 25 to 50 parts by weight of a crosslinkable monomer comprising one or more compounds having one or more ethylenically unsaturated groups in the molecule and containing not less than 5% by weight of one or more compounds having one or more hydroxyl groups and two or more ethylenically unsaturated groups in the molecule; and
(C) 0 to 10 parts by weight of a photopolymerization initiator;
the combined amount of components (A) to (C) being 100 parts by weight.

2. A photopolymerizable resin composition according to claim 1 comprising
(A) 45 to 65 parts by weight of a thermoplastic polymer binder obtained by copolymerizing
(1) 5 to 25% by weight of a first polymerizable substance comprising one or more compounds selected from the group consisting of styrene type compounds of the general formula

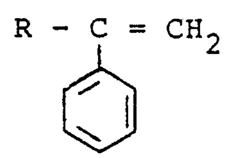

(I)

where R is hydrogen, an alkyl group of 1 to 6 carbon atoms, or a halogen, and ring-substituted derivatives thereof,
(2) 20 to 40% by weight of a second polymerizable substance comprising one or more compounds selected from the group consisting of alkyl acrylates having an alkyl group of 1 to 8 carbon atoms, and hydroxyalkyl acrylates having a hydroxyalkyl group of 2 to 8 carbon atoms,
(3) 30 to 55% by weight of a third polymerizable substance comprising one or more compounds selected from the group consisting of alkyl methacrylates having an alkyl group of 1 to 8 carbon atoms, and hydroxyalkyl methacrylates having a hydroxyalkyl group of 2 to 8 carbon atoms, and
(4) 18 to 30% by weight of a fourth polymerizable substance comprising one or more α,β-unsaturated carboxyl-containing monomers having 3 to 15 carbon atoms,
the thermoplastic polymer binder having a glass transition temperature (Tg) of 70 to 95°C as measured by differential scanning calorimetry (DSC);
(B) 30 to 45 parts by weight of a crosslinkable monomer comprising one or more compounds having one or more ethylenically unsaturated groups in the molecule and containing not less than 10% by weight of one or more compounds having one or more hydroxyl groups and two or more ethylenically unsaturated groups in the molecule; and
(C) 0.1 to 10 parts by weight of a photopolymerization initiator;
the combined amount of components (A) to (C) being 100 parts by weight.

3. A photopolymerizable resin composition as claimed in claim 1 or claim 2 wherein the amount of the photopolymerization initiator is 0.1 to 10 parts by weight.

4. A photopolymerizable resin composition as claimed in any preceding claim which additionally contains (D) tetrazole or a derivative thereof in an amount of 0.005 to 5 parts by weight per 100 parts by weight of the combination of components (A) to (C).

5. A photopolymerizable resin composition as claimed in any preceding claim which additionally contains (D) tetrazole or a derivative thereof in an amount of 0.01 to 1 part by weight per 100 parts by weight of the combination of components (A) to (C).

6. A photopolymerizable resin composition as claimed in any preceding claim wherein the crosslinkable monomer (B) contains not less than 10% by weight of one or more compounds having one or more hydroxyl groups and three or more ethylenically unsaturated groups in the molecule.

7. A photopolymerizable resin composition as claimed in claim 6, wherein the compound having one or more hydroxyl groups and three or more ethylenically unsaturated groups in the molecule is at least one of pentaerythritol triacrylate and dipentaerythritol pentaacrylate.

8. A gold plating method for covering desired areas of a metallic surface with gold, which comprises using, as a resist for protecting areas where it is not desired to deposit gold, the photo-cured product of a photopolymerizable resin composition characterised in that the composition is a composition according to any preceding claim.